# EUROPÄISCHE PATENTSCHRIFT

(11) **EP 2 837 891 B1**
(45) Veröffentlichungstag und Bekanntmachung des Hinweises auf die Patenterteilung: **05.12.2018**
(21) Anmeldenummer: 14174655.2
(22) Anmeldetag: 27.06.2014
(51) Int. Cl.: F24C 7/08, H05B 6/12

(54) **Kochfeld**
Cooktop
Plaque de cuisson

(30) Priorität: 03.07.2013 DE 102013213032
(43) Veröffentlichungstag der Anmeldung: 18.02.2015
(73) Patentinhaber: E.G.O. Elektro-Gerätebau GmbH, 75038 Oberderdingen (DE)
(72) Erfinder: Fiedler, Mathias, 75417 Mühlacker (DE)
(74) Vertreter: Patentanwälte Ruff, Wilhelm, Beier, Dauster & Partner mbB

(56) Entgegenhaltungen:
- EP-A1- 1 505 854
- EP-A1- 2 395 813
- EP-A1- 2 506 674
- EP-A1- 2 551 600
- EP-A1- 2 688 366
- EP-A2- 2 440 011
- WO-A1-2011/020721
- DE-A1-102009 036 161
- DE-A1-102011 006 021
- DE-A1-102011 087 217
- ES-A1- 2 170 033

## Beschreibung

### Anwendungsgebiet und Stand der Technik

Die Erfindung betrifft ein Kochfeld, insbesondere ein Elektrokochfeld, mit einer Kochfeldplatte und mit einer Vielzahl von Heizeinrichtungen und einer Bedieneinrichtung an dem Kochfeld.

Aus der EP 1206164 A2 und der EP 1463383 A1 ist es bekannt, an einem Elektrokochfeld eine Vielzahl von Heizeinrichtungen vorzusehen. Während bei konventionellen Elektrokochfeldern unabhängig von der Art der Beheizung vier oder fünf sozusagen diskrete und voneinander getrennte Kochstellen vorgesehen sind mit jeweils der Größe entsprechenden Heizeinrichtungen, ist es bei den genannten EP 1206164 A2 und der EP 1463383 A1 möglich, einen Großteil oder den größten Teil der Fläche der Kochfeldplatte sozusagen in kleinere Einheiten unterteilt individuell zu beheizen, also losgelöst von fest definierten Kochstellen. Die Größe eines aufgesetzten Topfes wird erkannt und nach Möglichkeit werden die von dem Topf überdeckten Heizeinrichtungen aktiviert. So ist eine gute und automatische Anpassung der beheizten Fläche an die Größe eines zu beheizenden Topfes möglich. Des Weiteren kann unabhängig von dem Aufsetzort des Topfes eine angepasste Beheizung erfolgen. Schließlich ist es sogar möglich, den Topf auf der Kochfeldplatte zu bewegen und die Beheizung sozusagen mitzuführen bzw. am neuen Standort des Topfes wieder die flächig angepasste Beheizung mit mehreren Heizeinrichtungen vorzunehmen.

Das Dokument EP 2 506 674 A1 beschreibt ein Induktionskochfeld mit einer Topferkennungsvorrichtung.

Das Dokument DE 10 2011 006 021 A1 beschreibt eine Bedieneinrichtung, die mehrere Anzeigeelemente, mehrere Bedienelemente unter einer lichtdurchlässigen Bedienfläche aufweist. Die Bedienelemente sind flächige kapazitive Sensorelemente.

Für eine Bedieneinrichtung dieser modernen Kochfelder scheinen sogenannten graphischen Touchscreen vorteilhaft. Damit kann an der Bedieneinrichtung auf vielfältige Art und Weise eine Anzeige sowohl von Betriebssituationen bezüglich der beheizten Bereiche bzw. aktivierten Heizeinrichtungen als auch von Leistungs- oder Betriebswerten erfolgen. Ebenso kann eine Bedienperson mittels der darin integrierten Bedienelemente als Berührsensoren die Bedienung vornehmen. Nachteilig an solchen Touchscreens ist deren Temperaturempfindlichkeit, eine hohe Lichtleistung der Rückseitenbeleuchtung, insbesondere bei einer Anordnung unter einer üblicherweise nur schlecht lichtdurchlässigen Glaskeramik-Kochfeldplatte, sowie deren hohe Kosten.

### Aufgabe und Lösung

Der Erfindung liegt die Aufgabe zugrunde, ein eingangs genanntes Kochfeld zu schaffen, mit dem Probleme des Stands der Technik vermieden werden können und es insbesondere möglich ist, eine Bedieneinrichtung eines solchen Kochfelds mit einer Vielzahl von Heizeinrichtungen praxistauglich und komfortabel zu begrenzten Kosten herzustellen.

Gelöst wird diese Aufgabe durch ein Kochfeld mit den Merkmalen des Anspruchs 1. Vorteilhafte sowie bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zum Inhalt der Beschreibung gemacht.

Es ist vorgesehen, dass das Kochfeld bzw. Elektrokochfeld eben eine Kochfeldplatte und eine Vielzahl von unter dieser Kochfeldplatte angeordneten Heizeinrichtungen aufweist. Diese Heizeinrichtungen sind benachbart zueinander angeordnet, insbesondere nahezu oder direkt aneinander anliegend, wobei sie mehr als die Hälfte der Fläche der Kochfeldplatte überdecken, vorteilhaft etwa 60% bis 90%. Das Kochfeld weist unter der Kochfeldplatte eine Bedieneinrichtung auf, die Anzeigen und mehrere identische Bedienelemente aufweist, unter Umständen auch noch weitere Bedienelemente. Des Weiteren weist sie eine Bedienfläche auf, unter der die Anzeigen und die identischen Bedienelemente bzw. alle Bedienelemente angeordnet sind. Die Bedienelemente können zusammen eine Art Anzeige- und Bedienfeld bilden.

Erfindungsgemäß weisen zumindest die identischen Bedienelemente jeweils ein Bedienelementgehäuse auf, welches einen Lichtkanal aufweist, der seitlich von lichtundurchlässigem Material umgeben oder darin integriert ist bzw. zur Seite abgeschirmt ist. Der Lichtkanal kann entweder offen ausgebildet sein oder, alternativ, lichtdurchlässiges bzw. lichtleitendes Material aufweisen, insbesondere als Lichtleitkörper oder -scheibe, insbesondere mit Diffusor- bzw. lichtverteilender Funktion. Oben auf dem Bedienelementgehäuse ist ein kapazitives Sensorelement vorgesehen, das an eine Unterseite der Bedienfläche angelegt ist. Das kapazitive Sensorelement ist vorteilhaft schmal und länglich ausgebildet und verläuft besonders vorteilhaft zumindest entlang von zwei oder drei Seiten des Bedienelementgehäuses, vorzugsweise entlang aller Seiten. Dann ist es abgewinkelt ausgebildet und kann eine Rahmenform aufweisen, wobei es bevorzugt den vorgenannten Lichtkanal nicht überdeckt und maximal mit 1% bis 10% Überdeckung umrahmt. Ein derartiges Sensorelement ist beispielsweise aus der DE 102012010321 A1 bekannt. Eine Anordnung der genannten identischen Bedienelemente in der Bedieneinrichtung entspricht dabei einer Anordnung der Heizeinrichtungen unter der Kochfeldplatte. Dies bedeutet, dass, natürlich maßstäblich verkleinert, genauso viele Bedienelemente nebeneinander und untereinander und in derselben Anordnung an der Bedieneinrichtung vorgesehen sind wie Heizeinrichtungen unter der Kochfeldplatte.

Dadurch ist es möglich, dass durch eine Anzeigefunktion mittels des Lichtkanals der Bedienelemente einer Bedienperson angezeigt werden kann, welche der Heizeinrichtungen in Betrieb ist, wobei sich hierfür ein Dauerleuchten eignet. Ebenso kann angezeigt werden, welche der Heizeinrichtungen für eine Leistungsveränderung ausgewählt ist, beispielsweise durch Blinken.

Durch die Funktion der Bedienelemente als Berührsensoren kann auch quasi jede Heizeinrichtung für sich genommen ausgewählt sowie ein- oder ausgeschaltet werden. Des Weiteren ist es möglich, dass eben jeweils Gruppen von Heizeinrichtungen zusammen als eine Art virtuelle Kochstelle je nach Überdeckung durch einen aufgestellten Topf eine Art Berührfläche bilden, die aus mehreren Berührsensoren und somit mehreren Bedienelementen zusammengesetzt ist. An jeder Stelle dieser Fläche kann eine Berührung durch einen darunter angeordneten Berührsensor bzw. ein entsprechendes Bedienelement erkannt werden.

Da eine Aufteilung der Fläche der Kochfeldplatte in beheizte Bereiche nicht feiner ist als in die einzelnen Heizeinrichtungen, wird eben eine Aufteilung der Anzeige auf entsprechende Art und Weise als ausreichend angesehen. So können beispielsweise 5 x 8 bis zu 12 x 20 oder sogar 15 x 25 Heizeinrichtungen vorgesehen sein, also insgesamt 40 bis 240 oder sogar 375 Stück, vorteilhaft etwa 100. Für die reine Anzeige der Heizeinrichtungen bzw. der beheizbaren Fläche des Kochfelds reicht dann eine solche Aufteilung als Auflösung, welche natürlich ganz erheblich unter derjenigen eines üblichen Touch-Displays liegt. Sie wird aber zumindest für die Darstellung der Heizeinrichtungen als ausreichend angesehen und sollte gleichzeitig ausreichend lichtstark sein.

Vorteilhaft ist die Anordnung der identischen Bedienelemente in der Bedieneinrichtung maßstäblich exakt verkleinert als Anordnung der Heizeinrichtungen unter der Kochfeldplatte. Die Verkleinerung kann zwischen 1:3 und 1:20 betragen, vorteilhaft zwischen 1:4 und 1:10.

Bei einer bevorzugten Ausgestaltung der Erfindung ist die Bedieneinrichtung im vorderen Bereich des Kochfelds vorgesehen, und zwar entlang der vorderen Seite mittig oder seitlich angeordnet. Dieser Bereich mit der Bedieneinrichtung sollte dann frei von Heizeinrichtungen sein, da zum Einen der Platz benötigt wird und zum Anderen abhängig von der Art der Beheizung zu hohe Temperaturen nahe an der Bedieneinrichtung vermieden werden sollten. Dabei kann bevorzugt auch in der Bedieneinrichtung ein entsprechender Bereich vorne in der Mitte frei bleiben, also die Bedienfläche hier keine zur Darstellung der Heizeinrichtung dienenden Anzeige- bzw. Bedienelemente aufweisen. Andere Bedienelemente bzw. gleiche Bedienelemente für einen anderen Zweck können hier aber vorgesehen sein. So kann beispielsweise in einem vorderen mittleren Bereich der Bedieneinrichtung an der Bedienfläche ein längliches Sensorelement bzw. ein länglicher Sensorelementstreifen vorgesehen sein, der vorteilhaft von links nach rechts verläuft und zur Einstellung einer Leistungsstufe ausgebildet ist. Derartige Sensorelementstreifen sind auch als Slider bekannt aus dem Stand der Technik, siehe beispielsweise die DE 102004044355 A1. Ein solcher Sensorelementstreifen kann mindestens 30% bis 50% der Breite der Bedienfläche einnehmen. Er kann vorteilhaft aus Bedienelementen gebildet werden, die wie die vorgenannten identischen Bedienelemente für Anzeige und Bedienung der Heizeinrichtungen dienen. Lediglich eine Leuchtanzeige kann anders ausgebildet sein bzw. eben entsprechend dem Zweck als Sensorelementstreifen. Er kann also auch sozusagen diskret aus einzelnen Bedienelementen aufgebaut sein.

In weiterer vorteilhafter Ausgestaltung der Erfindung kann die Bedieneinrichtung an der linken und/oder der rechten Seite, also die Menge der identischen Bedienelemente links und/oder rechts einrahmend, mehrere ebenfalls mit einer Leuchtanzeige kombinierte Zusatz-Bedienelemente aufweisen. Diese können für weitere Bedienfunktionen der Bedieneinrichtung ausgebildet und angesteuert sein, beispielsweise Timer-Funktionen, Boost-Funktionen odgl.. Insbesondere können an der Seite auch Leistungsstufen bestimmter virtueller Kochstellen auf der Kochfeldplatte angezeigt werden. Dabei können insgesamt beispielsweise vier bis sechs Leistungsstufenanzeigen vorgesehen sein entsprechend gleich vieler virtueller Kochstellen. Die Leuchtanzeigen können vorteilhaft in Form sogenannter Sieben-Segment-Anzeigen ausgebildet sein, und zwar einstellig oder zweistellig, abhängig von der Anzahl der gewünschten Leistungsstufen sowie eventuell als Anzeigen für Timer-Funktionen. Alternativen sind 23-Segment-Anzeigen entsprechend der DE 102011006021 A1 oder ein Entfall eines Sliders.

Grundsätzlich können die Heizeinrichtungen sowohl Strahlungsheizeinrichtungen als auch Induktionsheizeinrichtungen sein, evtl. auch Gasheizer, wobei Induktionsheizeinrichtungen bevorzugt werden. Diese weisen nämlich den Vorteil auf, dass sie quasi zwingend eine Topferkennung integriert haben und somit selber erkennen können, ob sie bis zu einem gewünschten vorgegebenen Grad von einem Topf überdeckt werden, also dass sie entsprechend aktiviert oder aktivierbar sind, was dann eben auch an der Anzeige der Bedieneinrichtung dargestellt wird. Dabei sind Ausgestaltungen denkbar, bei denen jede Induktionsheizeinrichtung jeweils eine eigene Leistungsversorgung bzw. eigene Leistungselektronik aufweist. Hierzu wird beispielsweise auf die eingangs genannte EP 1463383 A1 verwiesen. Entsprechende Strahlungsheizeinrichtungen sind aus der eingangs genannten EP 1206164 A2 bekannt. Dadurch ist der Aufbau einfacher und vor allem kann der Anschlussaufwand deutlich reduziert werden. Besonders vorteilhaft ist vorgesehen, dass die verwendeten Heizeinrichtungen sämtlich identisch sind.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine Ansicht eines erfindungsgemäßen Kochfelds mit einer Vielzahl von Heizeinrichtungen und einer Bedieneinrichtung,
- Fig. 2: eine vergrößerte Darstellung einer möglichen Anordnung mehrerer Heizeinrichtungen als Ausschnitt samt zugehöriger Anzeige auf der Bedieneinrichtung,
- Fig. 3: eine Variation einer Anordnung anders ausgebildeter Heizeinrichtungen samt entsprechender Anzeige auf der Bedieneinrichtung,
- Fig. 4: eine Schrägansicht auf ein Bedienelement für die Bedieneinrichtung,
- Fig. 5: eine seitliche Schnittdarstellung durch eine Bedieneinrichtung mit dem Bedienelement aus Fig. 4 und
- Fig. 6 bis 8: Draufsichten auf verschiedene Ausbildungen der Bedienelemente entsprechend Fig. 4 mit unterschiedlichen Anzeigen.

### Detaillierte Beschreibung der Ausführungsbeispiele

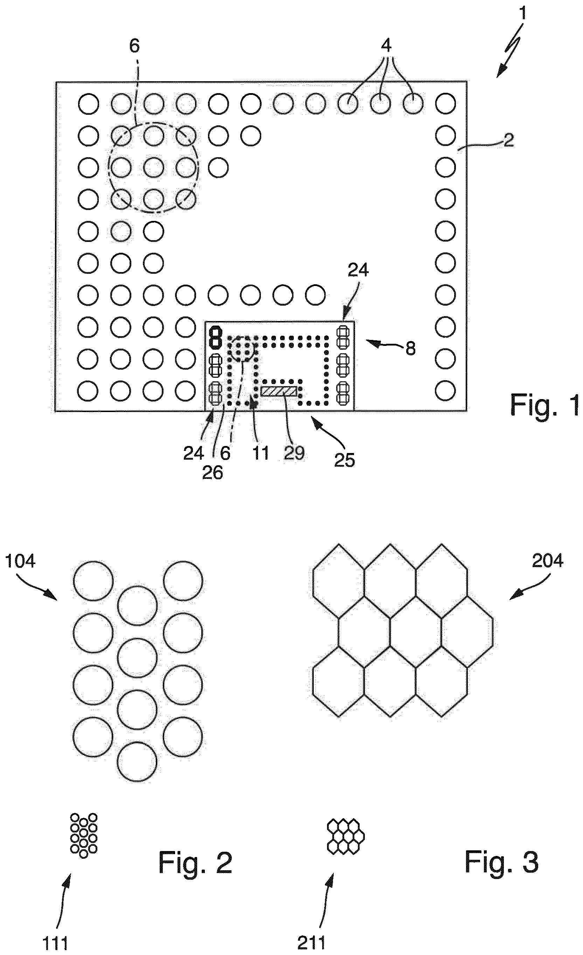

In der Fig. 1 ist ein erfindungsgemäßes Kochfeld 1 von oben dargestellt. Es weist eine Kochfeldplatte 2 auf, die vorteilhaft aus Glaskeramik besteht, wie dies grundsätzlich bekannt ist. Unter der Kochfeldplatte 2 ist eine Vielzahl von Heizeinrichtungen 4 angeordnet, die hier schematisch rund dargestellt sind, und zwar sind es zehn Heizeinrichtungen 4 in der einen und zwölf Heizeinrichtungen 4 in der anderen Richtung. Gestrichelt dargestellt ist ein aufgestellter Topf 6 in runder Form, der hier deutlich erkennbar insgesamt neun Heizeinrichtungen 4 überdeckt.

Ein freier Bereich 8 ist mittig an der Vorderkante der Kochfeldplatte 2 bzw. des Kochfelds 1 vorgesehen, wo sich keine Heizeinrichtungen 4 befinden. Hier ist eine Bedieneinrichtung 25 angeordnet, vorteilhaft unter derselben Kochfeldplatte 2, die zu diesem Zweck durchgängig und ohne Unterbrechung ausgebildet ist. Die Bedieneinrichtung 25 weist eine Bedienfläche 26 auf, die ihre gesamte Oberfläche bildet. Hier ist die Bedienfläche 26 durch die Kochfeldplatte 2 gebildet bzw. entspricht dieser, so dass die Bedienfläche 26 als ein Bereich der Kochfeldplatte 2 anzusehen ist.

Den wesentlichen Teil der Bedienfläche 26 bedecken Bedienelemente 11, die hier durch Punkte dargestellt sind, welche leuchtende Symbole sein können. Darauf wird nachgehend noch näher eingegangen. Allerdings leuchten immer nur einige dieser Leuchtsymbole, hier dargestellt im oberen linken Bereich neun Leuchtsymbole, die mit einem gestrichelt dargestellten Kreis 6' entsprechend dem Aufstellort des Topfes 6 gekennzeichnet sind. Es ist zu ersehen, dass ebenso viele Bedienelemente 11 wie Heizeinrichtungen 4 vorgesehen sind, und zwar auch in identischer Anordnung. Aktiviert sind jeweils nur die Leuchtsymbole, bei denen die entsprechenden Heizeinrichtungen 4 in Betrieb sind oder aber zumindest für eine Betriebswahleinstellung ausgewählt sind.

Links und rechts befinden sich an der Bedienfläche 6 drei an sich bekannte Sieben-Segment-Anzeigen 24 übereinander. Dies können auf unterschiedliche Art und Weise realisiert werden, entweder wie aus dem Stand der Technik bekannt mit einem einzigen Gehäuse mit sieben Leuchtbalken bzw. Segmenten darin und jeweils einer LED pro Leuchtbalken. Alternativ können sie auch durch Bauteile ähnlich der Bedienelemente 11 ausgebildet sein, wobei hierfür keine Touch- bzw. Berühr-Funktion vorgesehen ist, und zwar pro Segment eines.

Im mittleren vorderen Bereich der Bedienfläche 26 ist dort, wo beim Kochfeld 1 der freie Bereich 8 vorgesehen ist, ein Slider 29 als eingangs erläuterter, länglicher Sensorelementstreifen dargestellt. Zu dessen Ausbildung wird auf den vorgenannten Stand der Technik verwiesen. Alternativ kann er ebenfalls aus nachfolgend noch im Detail erläuterten Bedienelementen 11 bestehen, da seine einzelnen Segmente neben der Berühr-Funktion auch eine Anzeige- bzw. Leucht-Funktion haben können und sollten. Dies kann der Fachmann einfach anhand der vorgenannten DE 102004044355 A1 realisieren.

In der Fig. 2 ist in Vergrößerung eine Anzahl der Heizeinrichtungen 4 dargestellt, die hier jeweils rund bzw. kreisrund ausgebildet sind. Sie sind relativ nahe beieinander angeordnet, weisen aber noch einen geringen Abstand zueinander auf. Anders als in Fig. 1 sind hier benachbarte Spalten bzw. senkrechte Reihen der Heizeinrichtungen 4 etwas versetzt zueinander, um näher zusammenrücken zu können. Unten in der Fig. 2 ist entsprechend eine Anordnung der Bedienelemente 11 bzw. ihrer Leuchtsymbole dargestellt, die denselben Versatz aufweisen.

In Fig. 3 ist eine Abwandlung zur Fig. 2 dargestellt mit Heizeinrichtungen 204, die sechseckig ausgebildet sind. Des Weiteren berühren sie sich bzw. liegen aneinander an. Derartige sechseckige Heizeinrichtungen 204 sind beispielsweise aus der vorgenannten EP 1206164 A2 bekannt.

Entsprechend sind in der Fig. 3 unten die Bedienelemente 211 ausgebildet bzw. erzeugen sechseckige Leuchtsymbole. Diese allerdings liegen nicht direkt aneinander an, was aber kein Problem darstellt, da eine Bedienperson die Funktion bzw. Bedeutung der Leuchtanzeige dennoch problemlos erkennen kann.

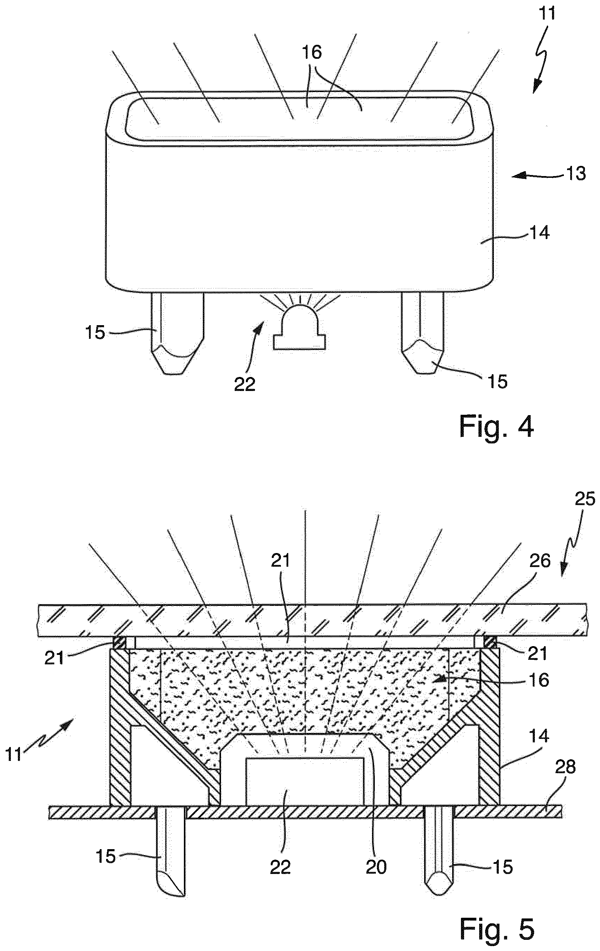

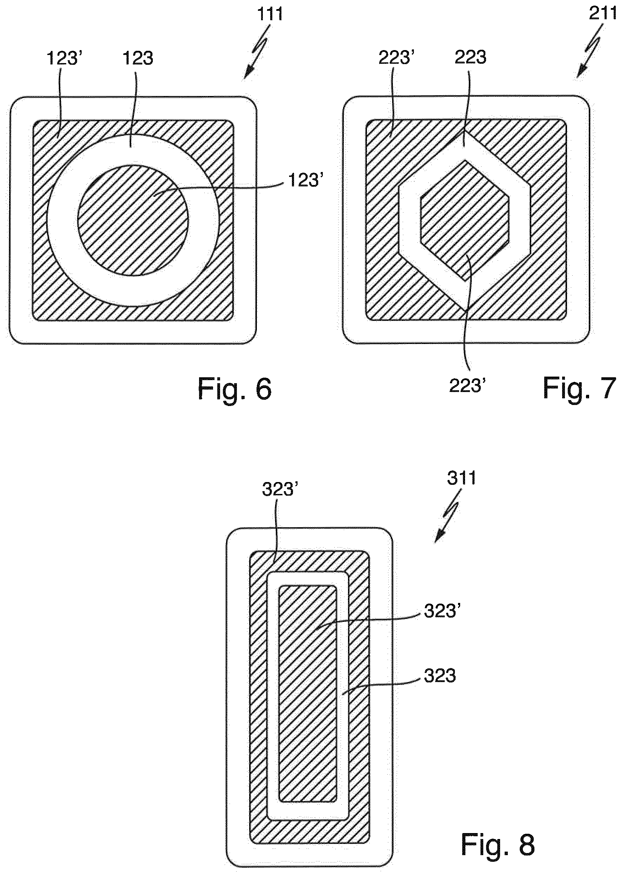

In der Fig. 4 ist vereinfacht dargestellt ein Bedienelement 11 zur Realisierung der Bedieneinrichtung 25. Das Bedienelement 11 weist ein Bedienelementgehäuse 13 mit einem Mantelteil 14 auf, welches unten zwei Befestigungsfüße 15 hat. Im Mantelteil 14 ist ein Lichtleiterteil 16 angeordnet. Darunter ist schematisch dargestellt eine LED 22 zur Durchleuchtung. Das Lichtleiterteil 16 ist vorteilhaft zur Erzeugung eines Leuchtsymbols in bestimmter Form ausgebildet, was nachher mit Bezug zu den Fig. 6 bis 8 noch erläutert wird. Dazu kann auf der Oberseite des Lichtleiterteils 16 eine Art Maskierung, alternativ eine Scheibe aus dünnem Material, aufgebracht sein.

In der Fig. 5 ist ein seitlicher Schnitt durch die Bedieneinrichtung 25 quasi einer Bedienfläche 26 dargestellt. Hier ist auch zu erkennen, wie aus der vorgenannten DE 102012010321.2 bekannt ist, dass auf der Oberseite des Bedienelements 11 bzw. außen auf dem Mantelteil 14 umlaufend ein elektrisch leitfähiger Rahmen 21 aus elastischem Material vorgesehen ist, der ein kapazitives Sensorelement bildet. Somit wirkt das Bedienelement 11 als kapazitives Bedienelement.

Aus der Fig. 5 ist auch zu ersehen, wie das Bedienelement 11 mit den Befestigungsfüßen 15 auf einer Leiterplatte 28 angeordnet ist, welche die LED 22 als SMD-LED trägt. Diese ist quasi von dem Bedienelement 11 überdeckt und kann durch den Lichtleiterteil 16 hindurchstrahlen und somit auch durch die Bedienfläche 26 bzw. die Kochfeldplatte 2.

In den Fig. 6 bis 8 sind verschiedene Formen von Leuchtsymbolen dargestellt, welche mit den Bedienelementen dargestellt werden können. In Fig. 6 weist ein Bedienelement 111 mit grundsätzlich angenähert quadratischer Grundform einen kreisringförmigen Ausschnitt 123 auf, der innen und außen durch eine Abdeckung 123' auf dem Lichtleiterteil in der Mitte gebildet wird. Leuchtet eine LED unter dem Bedienelement 111, so ist der kreisringförmige Ausschnitt 123 als Leuchtsymbol zu erkennen, wie dies in Fig. 2 angedeutet ist.

In der Fig. 7 ist ein Bedienelement 211 dargestellt, bei dem ein sechseckiger Ausschnitt 223 vorgesehen ist, der durch Abdeckungen 223' innen und außen gebildet wird. Dies entspricht quasi der Fig. 3.

In Fig. 8 ist ein Bedienelement 311 dargestellt mit einem Leuchtsymbol in rechteckiger Form, gebildet durch einen rechteckigen Ausschnitt 323. Für den Ausschnitt 323 sind innen und außen Abdeckungen 323' auf dem Lichtleiterteil vorgesehen. Alternativ ist hier auch leicht vorstellbar, dass die äußere Abdeckung 323' ein Ausschnitt ist und somit lichtdurchlässig ist, während die Fläche des Ausschnitts 323 und die innere Abdeckung 323' lichtundurchlässig sind. So kann ein maximal großes rechteckiges Leuchtsymbol erzeugt werden.

## Patentansprüche

1. Kochfeld (1) mit einer Kochfeldplatte (2) und mit einer Vielzahl von Heizeinrichtungen (4, 104, 204), die benachbart zueinander unter der Kochfeldplatte angeordnet sind und mehr als die Hälfte der Fläche der Kochfeldplatte (2) überdecken,
wobei eine Bedieneinrichtung (25) an dem Kochfeld und unter der Kochfeldplatte vorgesehen ist mit Anzeigen (24) und mehreren identischen Bedienelementen (11, 111, 211),
wobei die Bedieneinrichtung (25) eine Bedienfläche (26) aufweist, unter der die Anzeigen (24) und Bedienelemente (11, 111, 211) angeordnet sind,
**dadurch gekennzeichnet, dass** die identischen Bedienelemente (11, 111, 211) jeweils ein Bedienelementgehäuse (13) aufweisen mit einem Lichtkanal (16), der seitlich von lichtundurchlässigem Material (14) umgeben ist,
wobei oben auf dem Bedienelementgehäuse (13) ein zumindest entlang zwei oder drei Seiten verlaufendes, schmales längliches kapazitives Sensorelement (21) vorgesehen ist, das an eine Unterseite der Bedienfläche (26) angelegt ist,
wobei eine Anordnung der identischen Bedienelemente (11, 111, 211) in der Bedieneinrichtung (25) einer Anordnung der Heizeinrichtungen (4, 104, 204) unter der Kochfeldplatte (2) entspricht.

2. Kochfeld nach Anspruch 1, **dadurch gekennzeichnet, dass** die Anordnung der identischen Bedienelemente (11, 111, 211) in der Bedieneinrichtung (25) einer Anordnung der Heizeinrichtungen (4, 104, 204) unter der Kochfeldplatte (2) maßstäblich verkleinert exakt entspricht und nachgebildet ist.

3. Kochfeld nach Anspruch 1 oder 2, **dadurch gekennzeichnet, dass** die Bedieneinrichtung (25) im vorderen Bereich des Kochfelds (1) und mittig angeordnet ist und dieser Bereich frei von Heizeinrichtungen (4, 104, 204) ausgebildet ist.

4. Kochfeld nach Anspruch 3, **dadurch gekennzeichnet, dass** ein entsprechender freier Bereich auch in der Bedieneinrichtung (25) bzgl. der identischen Bedienelemente (11, 111, 211) vorgesehen ist.

5. Kochfeld nach einem der vorhergehenden Ansprüche, **dadurch gekennzeichnet, dass** die Bedieneinrichtung (25) im vorderen Bereich bzw. vor den Bedienelementen (11, 111, 211) einen länglichen Sensorelementstreifen (29) aufweist als Einstell-Bedienelement.

6. Kochfeld nach Anspruch 5, **dadurch gekennzeichnet, dass** der Sensorelementstreifen (29) mindestens 50% der Breite der Bedienfläche (26) einnimmt.

7. Kochfeld nach einem der vorhergehenden Ansprüche, **dadurch gekennzeichnet, dass** die Bedieneinrichtung (25) auf der linken und/oder der rechten Seite mehrere mit einer Leuchtanzeige (24) kombinierte Zusatz-Bedienelemente aufweist.

8. Kochfeld nach Anspruch 7, **dadurch gekennzeichnet, dass** die Bedieneinrichtung (25) an beiden Seiten jeweils mindestens zwei mit einer Leuchtanzeige (24) kombinierte Zusatz-Bedienelemente entlang der Seite aufweist.

9. Kochfeld nach einem der vorhergehenden Ansprüche, **dadurch gekennzeichnet, dass** es bis zu 12 mal 20 Heizeinrichtungen (4, 104, 204) aufweist.

10. Kochfeld nach Anspruch 9, **dadurch gekennzeichnet, dass** die Heizeinrichtungen (4, 104, 204) in regelmäßiger Anordnung vorgesehen sind.

11. Kochfeld nach Anspruch 10, **dadurch gekennzeichnet, dass** die Heizeinrichtungen (104, 204) mit jeweils gleichem Abstand zu benachbarten Heizeinrichtungen vorgesehen sind.

12. Kochfeld nach einem der vorhergehenden Ansprüche, **dadurch gekennzeichnet, dass** die Heizeinrichtungen (4, 104, 204) Induktionsheizeinrichtungen sind.

13. Kochfeld nach Anspruch 12, **dadurch gekennzeichnet, dass** jede Induktionsheizeinrichtung jeweils eine eigene Leistungsversorgung bzw. Leistungselektronik aufweist.

14. Kochfeld nach einem der vorhergehenden Ansprüche, **dadurch gekennzeichnet, dass** die Heizeinrichtungen (4, 104, 204) identisch sind.

## Claims

1. Cooktop (1) having a cooktop plate (2) and having a plurality of heating devices (4, 104, 204) which are arranged adjacent to each other underneath the cooktop plate and cover more than half of the surface area of the cooktop plate (2),
wherein an operator control device (25) is provided on the cooktop and underneath the cooktop plate having displays (24) and a plurality of identical operator control elements (11, 111, 211),
wherein the operator control device (25) has an operator control surface (26) with the displays (24) and operator control elements (11, 111, 211) being disposed underneath,
**characterized in that**
each of the identical operator control elements (11, 111, 211) has an operator control element housing (13) including a light channel (16) which is laterally surrounded by opaque material (14),
wherein on top of the operator control element housing (13) is provided a narrow elongate capacitive sensor element (21), extending at least along two or three sides and resting on a bottom side of the operator control surface (26),
wherein an arrangement of the identical operator control elements (11, 111, 211) in the operator control device (25) corresponds to an arrangement of the heating devices (4, 104, 204) underneath the cooktop plate (2).

2. Cooktop according to claim 1, **characterized in that** the arrangement of the identical operator control elements (11, 111, 211) in the operator control device (25) corresponds to and is a replication of an arrangement of the heating devices (4, 104, 204) underneath the cooktop plate (2) in a exactly scaled-down pattern.

3. Cooktop according to claim 1 or 2, **characterized in that** the operator control device (25) is arranged centrally in a front region of the cooktop (1) and said region is free of heating devices (4, 104, 204).

4. Cooktop according to claim 3, **characterized in that** a corresponding free region is provided also in the operator control device (25) in relation to the identical operator control elements (11, 111, 211).

5. Cooktop according to any of the preceding claims, **characterized in that** the operator control device (25) has an elongate sensor element strip (29) as an adjusting operator control element in the front region or in front of the operator control elements (11, 111, 211).

6. Cooktop according to claim 5, **characterized in that** the sensor element strip (29) occupies at least 50% of the width of the operator control surface (26).

7. Cooktop according to any of the preceding claims, **characterized in that** the operator control device (25) has a plurality of additional operator control elements combined with an illuminated display (24) on the left and/or on the right side.

8. Cooktop according to claim 7, **characterized in that** the operator control device (25) has on both sides in each case at least two additional operator control elements combined with an illuminated display (24) along the side.

9. Cooktop according to any of the preceding claims, **characterized in that** up to 12 times 20 heating devices (4, 104, 204) are provided.

10. Cooktop according to claim 9, **characterized in that** the heating devices (4, 104, 204) are provided in a regular arrangement.

11. Cooktop according to claim 10, **characterized in that** the heating devices (4, 104, 204) are provided in each case with the same distance to adjacent heating devices.

12. Cooktop according to any of the preceding claims, **characterized in that** the heating devices (4, 104, 204) are induction heating devices.

13. Cooktop according to claim 12, **characterized in that** each induction heating device has a respective distinct power supply and/or power electronics.

14. Cooktop according to any of the preceding claims, **characterized in that** the heating devices (4, 104, 204) are identical.

## Revendications

1. Table de cuisson (1) comprenant une plaque de cuisson (2) et comprenant une pluralité de dispositifs chauffants (4, 104, 204) qui sont disposés adjacents les uns aux autres sous la plaque de cuisson et qui recouvrent plus de la moitié de la surface de la plaque de cuisson (2),
un dispositif de commande (25) se trouvant sur la table de cuisson et sous la plaque de cuisson, lequel comprend des indicateurs (24) et plusieurs éléments de commande (11, 111, 211) identiques,
le dispositif de commande (25) possédant une surface de commande (26) sous laquelle sont disposés les indicateurs (24) et les éléments de commande (11, 111, 211),
**caractérisée en ce que** les éléments de commande (11, 111, 211) identiques possèdent respectivement un boîtier d'élément de commande (13) pourvu d'un canal de lumière (16) qui est entouré latéralement par un matériau opaque (14),
un élément de détection (21) capacitif étroit allongé, qui s'étend au moins le long de deux ou de trois côtés, se trouvant en haut sur le boîtier d'élément de commande (13) et étant appliqué au niveau d'un côté inférieur de la surface de commande (26),
un arrangement des éléments de commande (11, 111, 211) identiques dans le dispositif de commande (25) correspondant à un arrangement des dispositifs chauffants (4, 104, 204) sous la plaque de cuisson (2).

2. Table de cuisson selon la revendication 1, **caractérisée en ce que** l'arrangement des éléments de commande (11, 111, 211) identiques dans le dispositif de commande (25) correspond exactement à une échelle réduite à un arrangement des dispositifs chauffants (4, 104, 204) sous la plaque de cuisson (2) et reproduit celui-ci.

3. Table de cuisson selon la revendication 1 ou 2, **caractérisée en ce que** le dispositif de commande (25) est disposé dans la zone avant de la table de cuisson (1) et au centre et cette zone est configurée exempte de dispositifs chauffants (4, 104, 204).

4. Table de cuisson selon la revendication 3, **caractérisée en ce qu'**une zone libre correspondante se trouve également dans le dispositif de commande (25) en rapport avec les éléments de commande (11, 111, 211) identiques.

5. Table de cuisson selon l'une des revendications précédentes, **caractérisée en ce que** le dispositif de commande (25) possède dans la zone avant ou devant les éléments de commande (11, 111, 211) une bande d'éléments capteurs (29) allongée faisant office d'élément de commande de réglage.

6. Table de cuisson selon la revendication 5, **caractérisée en ce que** la bande d'éléments capteurs (29) occupe au moins 50 % de la largeur de la surface de commande (26).

7. Table de cuisson selon l'une des revendications précédentes, **caractérisée en ce que** le dispositif de commande (25) possède sur le côté gauche et/ou sur le côté droit plusieurs éléments de commande supplémentaires combinés avec un indicateur lumineux (24).

8. Table de cuisson selon la revendication 7, **caractérisée en ce que** le dispositif de commande (25) possède des deux côtés respectivement au moins deux éléments de commande supplémentaires le long du côté, combinés avec un indicateur lumineux (24).

9. Table de cuisson selon l'une des revendications précédentes, **caractérisée en ce qu'**elle possède jusqu'à 12 fois 20 dispositifs chauffants (4, 104, 204).

10. Table de cuisson selon la revendication 9, **caractérisée en ce que** les dispositifs chauffants (4, 104, 204) se présentent dans un arrangement régulier.

11. Table de cuisson selon la revendication 10, **caractérisée en ce que** les dispositifs chauffants (104, 204) sont disposés respectivement avec un écart identique par rapport aux dispositifs chauffants voisins.

12. Table de cuisson selon l'une des revendications précédentes, **caractérisée en ce que** les dispositifs chauffants (4, 104, 204) sont des dispositifs chauffants à induction.

13. Table de cuisson selon la revendication 12, **caractérisée en ce que** chaque dispositif chauffant à induction possède respectivement une alimentation en puissance ou une électronique de puissance propre.

14. Table de cuisson selon l'une des revendications précédentes, **caractérisée en ce que** les dispositifs chauffants (4, 104, 204) sont identiques.
